# EUROPEAN PATENT APPLICATION

(11) **EP 4 502 068 A1**
(43) Date of publication of application: **05.02.2025**
(21) Application number: 23779941.6
(22) Date of filing: 22.03.2023
(51) Int. Cl.: C08L 83/07, C08K 3/11, C08L 83/05, H01L 23/29, H01L 23/31

(54) **ULTRAVIOLET CURABLE SILICONE COMPOSITION**

(30) Priority: 31.03.2022 JP 2022058758
(71) Applicant: Momentive Performance Materials Japan LLC, Tokyo 107-6119 (JP)
(72) Inventor: OKAWA Koji, Tokyo 107-6119 (JP); MOCHIZUKI Kikuo, Tokyo 107-6119 (JP)
(74) Representative: Müller-Boré & Partner Patentanwälte PartG mbB
(86) International application number: PCT/JP2023/011185
(87) International publication number: WO 2023/189929

(57) **Abstract**

The present invention provides an UV-curable silicone composition which has excellent curability in a portion that is not irradiated with light and in the thickness direction. The UV-curable silicone composition comprises: a polyorganosiloxane (A) having at least two alkenyl groups per molecule and having an alkenyl group content of 0.08 mmol/g or more on an average; a polyorganohydrogensiloxane (B) having per molecule at least three hydrogen atoms bonded to silicon atoms; and a platinum catalyst (C) which is capable of being activated by an ultraviolet light. With respect to a cured product that is obtained by irradiating the composition with ultraviolet light having a wavelength of 365 nm for 45 seconds at an illuminance of 100 mW/cm² with a diameter of 7.0 mm in a yellow room and subsequently storing the resulting composition at 23°C for 16 hours, the curing diameter at a depth of 1.8 mm is 10.8 mm or more.

## Description

### TECHNICAL FIELD

The present invention relates to a UV-curable silicone composition, particularly relates to a UV-curable silicone composition advantageous in that a cured product of the composition can be suitably used as encapsulants for, for example, electric parts and electronic parts.

### BACKGROUND ART

Silicone compositions have excellent heat resistance and exhibit good adhesion and bonding properties with respect to, for example, semiconductor devices, such as ICs and LSIs; electric and electronic components populated with such semiconductor devices, capacitors, resistors, and the like; and optical components, such as lenses, mirrors, filters, and prisms. In these components, for example, silicone compositions are used as elastic adhesives, sealants, coating materials, and electrically insulating sealing materials. In particular, UV-curable addition reaction-type silicone compositions that utilize hydrosilylation reaction have gained wide use because they can be cured by short time UV irradiation, thereby offering excellent productivity, and can bond members together satisfactorily.

Among such UV-curable silicone compositions, Patent Literature 1 discloses a UV-curable organopolysiloxane gel composition for a damping material for an objective lens driving device that includes specific proportions of (A) an organopolysiloxane having an average of 0.1 or more silicon-bonded alkenyl group in the molecule; (B) an organohydrogenpolysiloxane having two or more silicon-bonded hydrogen atoms in the molecule; and (C) a photoactive platinum complex curing catalyst. The composition is described as both offering a certain advantage in polymer design and having quick UV curability.

Furthermore, Patent Literature 2 discloses a UV-curable liquid silicone composition for an image display device that has a predetermined viscosity and includes specific proportions of (A) an organopolysiloxane having a viscosity at 25°C of 50 to 100,000 mPa s and containing at least two alkenyl groups in the molecule; (B) an organohydrogenpolysiloxane, for example, a linear organohydrogenpolysiloxane having silicon-bonded hydrogen atoms (Si-H groups) only at both terminals of the molecular chain; and (C) one or more kinds of photoactive hydrosilylation reaction catalysts selected from specific compounds. The composition is described as being able to be cured in several minutes to several tens of minutes under mild temperature conditions of 100°C or below to give a cured product having good mechanical properties and optical properties.

The UV-curable silicone composition has problems in that irradiation with an ultraviolet light initiates curing of the composition and therefore the composition flows before being completely cured, and in that the composition is unsatisfactorily cured in the portion thereof which is not exposed to an ultraviolet light. As a method for solving the problems, various methods for curing the UV-curable silicone composition have been proposed. For example, as a method for the purpose of curing a composition while maintaining the shape on the initial stage of heating, Patent Literature 3 discloses a method for curing a composition, which comprises the step of irradiating the composition with a light having a specific emission spectrum, and then heating the resultant composition. Further, as a method for the purpose of uniformly curing even the portion of a composition which is not exposed to a light or a thick molded article of the composition, Patent Literature 4 discloses a method for curing a composition, which comprises a first step of irradiating the composition with an ultraviolet light to increase the catalytic activity of a photoactive platinum complex curing catalyst, and a second step of applying the composition obtained in the first step to a desired position and curing the composition.

### CITATION LIST

### Patent Literature

Patent Literature 1: JP 2003-213132 A
Patent Literature 2: JP 2019-210351 A
Patent Literature 3: JP 2012-121960 A
Patent Literature 4: JP 2013-87199 A

### SUMMARY OF INVENTION

### Technical Problem

The UV-curable silicone compositions disclosed in Patent Literatures 1 and 2 exhibit predetermined mechanical properties and optical properties after cured by irradiation with an ultraviolet light, but have a problem in that the composition has unsatisfactory curing properties in the portion thereof which is not exposed to a light and in the thicknesswise direction, so that a cured product of the composition cannot achieve stable quality. Further, the methods for curing a composition disclosed in Patent Literatures 3 and 4 have disadvantages in that additional facilities are required and in that the operations are cumbersome, and therefore a UV-curable silicone composition that provides a cured product having stable quality without using these methods has been desired.

An object of the present invention is to provide a UV-curable silicone composition having excellent curing properties in the portion thereof which is not exposed to a light and in the thicknesswise direction.

### Solution to Problem

The present inventors have conducted extensive and intensive studies with a view toward solving the above-mentioned problems. As a result, it has been found that, when a predetermined alkenyl group-containing polyorganosiloxane and polyorganohydrogensiloxane are used in the composition and the amount of the platinum catalyst incorporated into the composition is in a predetermined range, the composition can be improved in curing properties, and the present invention has been completed.

The present invention is directed to the following items [1] to [11].
[1] A UV-curable silicone composition comprising: a polyorganosiloxane (A) having at least two alkenyl groups per molecule and having an alkenyl group content of 0.08 mmol/g or more on an average; a polyorganohydrogensiloxane (B) having per molecule at least three hydrogen atoms bonded to silicon atoms; and a platinum catalyst (C) which is capable of being activated by an ultraviolet light, the component (B) comprising a polyorganohydrogensiloxane (B1) having an R^{c1}₂HSiO_{1/2} unit (wherein each R^{c1} is independently a C₁-C₆ alkyl group or a C₆-C₂₀ aryl group) and a SiO_{4/2} unit, wherein the amount of the component (C) incorporated into the composition is 8 to 400 ppm, in terms of a platinum metal mass, wherein the composition has a viscosity of 10 to 10,000 mPa•s at 23°C, and wherein a cured product of the composition has a cured diameter of 10.8 mm or more at a depth of 1.8 mm, wherein the cured product is obtained by irradiating the composition with an ultraviolet light having a diameter of 7.0 mm, an illuminance of 100 mW/cm², and a wavelength of 365 nm for 45 seconds in a yellow room, and then allowing the resultant composition to stand at 23°C for 16 hours.
[2] The UV-curable silicone composition according to item [1] above, wherein the component (A) contains a linear polyorganosiloxane, and the component (A) has an alkenyl group content of 0.09 to 1.8 mmol/g on an average.
[3] The UV-curable silicone composition according to item [1] or [2] above, wherein the amount of the component (C) incorporated into the composition is 40 to 350 ppm, in terms of a platinum metal mass.
[4] The UV-curable silicone composition according to any one of items [1] to [3] above, wherein the component (B1) is a polyorganohydrogensiloxane having a structure in which 3 to 6 SiO_{4/2} units and 6 to 12 R^{c1}₂HSiO_{1/2} units are bonded to each other.
[5] The UV-curable silicone composition according to any one of items [1] to [4] above, wherein the component (C) is a platinum catalyst having a cyclic diene compound as a ligand.
[6] The UV-curable silicone composition according to any one of items [1] to [5] above, wherein a H_{B}/Vi_{A} ratio, which is the ratio of a molar number H_{B} of the hydrogen atoms bonded to silicon atoms of the component (B) to a molar number Vi_{A} of the alkenyl groups of the component (A), is 0.30 to 3.5.
[7] A potting material comprising the UV-curable silicone composition according to any one of items [1] to [6] above.
[8] The potting material according to item [7] above, which is for use in a connector pin.
[9] An encapsulant comprising a cured product of the UV-curable silicone composition according to any one of items [1] to [6] above.
[10] The encapsulant according to item [9] above, which is for use in an electric part or an electronic part.
[11] The encapsulant according to item [10] above, wherein the electric part or electronic part is a connector having a connector pin.

### Advantageous Effects of Invention

In the present invention, there is provided a UV-curable silicone composition having excellent curing properties in the portion thereof which is not exposed to a light and in the thicknesswise direction.

### BRIEF DESCRIPTION OF DRAWINGS

[Fig. 1] Fig. 1 is a photograph of an apparatus for measuring a cured diameter in a yellow room, taken from above.
[Fig. 2] Fig. 2 is a schematic diagram of the apparatus of Fig. 1 as viewed from above.
[Fig. 3] Fig. 3 is a cross-sectional diagram of Fig. 2, taken along line A-A'.
[Fig. 4] Fig. 4 is a schematic diagram explaining the cured region and cured diameter after irradiation with an ultraviolet light in Figs. 2 and 3.
[Fig. 5] Fig. 5 is a graph showing the relationship between the amount of the platinum incorporated with the cured diameter in the upper surface (depth: 0 mm) and the lower surface (depth: 1.8 mm) with respect to Examples 1 to 10 and Comparative Example 5.
[Fig. 6] Fig. 6 is a graph showing the relationship between the amount of the platinum incorporated with the cured area of the unirradiated portion in the upper surface (depth: 0 mm) and the lower surface (depth: 1.8 mm) with respect to Examples 1 to 10 and Comparative Example 5.

### DESCRIPTION OF EMBODIMENTS

The UV-curable silicone composition comprises a polyorganosiloxane (A) having at least two alkenyl groups per molecule and having an alkenyl group content of 0.08 mmol/g or more on an average; a polyorganohydrogensiloxane (B) having per molecule at least three hydrogen atoms bonded to silicon atoms; and a platinum catalyst (C) which is capable of being activated by an ultraviolet light, the component (B) comprising a polyorganohydrogensiloxane (B1) having an R^{c1}₂HSiO_{1/2} unit (wherein each R^{c1} is independently a C₁-C₆ alkyl group or a C₆-C₂₀ aryl group) and a SiO_{4/2} unit, wherein the amount of the component (C) incorporated into the composition is 8 to 400 ppm, in terms of a platinum metal mass, wherein the composition has a viscosity of 10 to 10,000 mPa•s at 23°C, and wherein a cured product of the composition has a cured diameter of 10.8 mm or more at a depth of 1.8 mm, wherein the cured product is obtained by irradiating the composition with an ultraviolet light having a diameter of 7.0 mm, an illuminance of 100 mW/cm², and a wavelength of 365 nm for 45 seconds in a yellow room, and then allowing the resultant composition to stand at 23°C for 16 hours. The UV-curable silicone composition of the present invention has excellent curing properties in the portion thereof which is not exposed to a light and in the thicknesswise direction.

The term "organic group" used in the present specification means a group containing carbon. The valence of the organic group is expressed by indicating "n-valent" wherein n is an arbitrary natural number. Accordingly, for example, the term "monovalent organic group" means a group containing carbon and having only one bonding site. An element other than carbon may have a bonding site. Even when the valence is not specified, those skilled in the art can grasp an appropriate valence from the context.

The term "hydrocarbon group" used in the present specification means a group containing carbon and hydrogen, which results from elimination of at least one hydrogen atom from a molecule. With respect to the hydrocarbon group, there is no particular limitation, but examples include hydrocarbon groups having 1 to 20 carbon atoms and being optionally substituted with one or more substituents, such as an aliphatic hydrocarbon group and an aromatic hydrocarbon group. The "aliphatic hydrocarbon group" may be linear, branched, or cyclic, and may be saturated or unsaturated. Further, the hydrocarbon group may contain one or more cyclic structures. The hydrocarbon group may have in the end or in the middle of molecular chain thereof one or more heteroatoms or structures containing a heteroatom, such as a nitrogen atom (N), an oxygen atom (O), a sulfur atom (S), a silicon atom (Si), an amide linkage, a sulfonyl linkage, a siloxane bond, a carbonyl group, or a carbonyloxy group.

With respect to the substituent for the "hydrocarbon group" used in the present specification, there is no particular limitation, but examples include halogen atoms; and groups which are optionally substituted with one or more halogen atoms, and which are selected from a C₁₋₆ alkyl group, a C₂₋₆ alkenyl group, a C₂₋₆ alkynyl group, a C₃₋₁₀ cycloalkyl group, a C₃₋₁₀ unsaturated cycloalkyl group, 5- to 10-membered heterocyclic groups, 5- to 10-membered unsaturated heterocyclic groups, a C₆₋₁₀ aryl group, and 5- to 10-membered heteroaryl groups.

In the present specification, an alkyl group and a phenyl group may be unsubstituted or substituted unless otherwise specified. With respect to the substituent for the above groups, there is no particular limitation, but examples include one or more groups selected from a halogen atom, a C₁₋₆ alkyl group, a C₂₋₆ alkenyl group, and a C₂₋₆ alkynyl group.

In the present specification, in the description of the structure of the siloxane compound, the structural units of the siloxane compound are frequently indicated using the abbreviations shown below. Hereinafter, these structural units are frequently respectively referred to as, for example, "M unit" and "D unit".

M: (CH₃)₃SiO_{1/2}

M^{H}: H(CH₃)₂SiO_{1/2}

M^{Vi}: CH₂=CH(CH₃)₂SiO_{1/2}

D: (CH₃)₂SiO_{2/2}

D^{H}: H(CH₃)SiO_{2/2}

D^{Vi}: CH₂=CH(CH₃)SiO_{2/2}

T: CH₃SiO_{3/2}

Q: SiO_{4/2} (tetrafunctional)

The siloxane compound is composed of a combination of the above-mentioned structural units, but may at least partially contain the structural units, of which the methyl group is replaced with another group, e.g., a halogen, such as fluorine, or a hydrocarbon group, such as a phenyl group. Further, for example, when a structure is indicated by D^{H}₂₀D₂₀, it is understood that the indication is not intended to show that 20 D^{H} units are continuously disposed and then 20 D units are continuously disposed, but shows that the individual units may be arbitrarily arranged. The siloxane compound can have various three-dimensional structures using a T unit or a Q unit.

### <Polyorganosiloxane (A) having at least two alkenyl groups per molecule and having an alkenyl group content of 0.08 mmol/g or more on an average>

Component (A) is a polyorganosiloxane having at least two alkenyl groups per molecule and having an alkenyl group content of 0.08 mmol/g or more on an average. The component (A) serves as a base polymer of the UV-curable silicone composition. The alkenyl groups may be bonded to an end of the molecular chain of the molecular principal chain, or may be bonded to a side chain in the middle of the molecular chain, or may be bonded to both of them. In the present specification, the molecular principal chain indicates the relatively longest bonding chain in the molecule. With respect to the molecular structure of the component (A), there is no particular limitation as long as the molecular structure has a siloxane bond as a main skeleton, and the molecular structure may be linear, branched, cyclic, or of a three-dimensional network, and the siloxane skeleton may be intermitted by a divalent organic group. The component (A) may be used individually or in combination.

The component (A) has at least two alkenyl groups per molecule. The component (A) can be a mixture of a plurality of polyorganosiloxanes having at least two alkenyl groups per molecule. Particularly, from the viewpoint of forming a stable three-dimensional structure in the composition being cured due to a crosslinking reaction to obtain a cured product having an appropriate hardness, the component (A) preferably contains a linear polyorganosiloxane, more preferably contains a linear polyorganosiloxane having one alkenyl group at each of the ends of the molecular principal chain. In this case, the component (A) preferably contains a linear polyorganosiloxane in an amount of 30% by mass or more, more preferably 50% by mass or more, further preferably 80% by mass or more, based on the mass of the component (A) (100% by mass). The upper limit of the amount of the linear polyorganosiloxane contained, based on the mass of the component (A) (100% by mass), is 100% by mass.

With respect to the alkenyl group, there is no particular limitation as long as it is a group having a carbon-carbon double bond and being capable of undergoing an addition reaction. The alkenyl group preferably has 2 to 20 carbon atoms, more preferably 2 to 8 carbon atoms, further preferably 2 to 6 carbon atoms. The alkenyl group may have a branched structure or a cyclic structure. The position of the carbon-carbon double bond in the hydrocarbon constituting the alkenyl group can be an arbitrary position. In view of the reactivity, the carbon-carbon double bond is preferably positioned at an end of the group. As a preferred example of the alkenyl group, there can be mentioned a vinyl group in view of easy synthesis of polyorganosiloxane.

The component (A) has an alkenyl group content of 0.08 mmol/g or more on an average, preferably 0.08 to 11.0 mmol/g, more preferably 0.09 to 5.0 mmol/g, further preferably 0.09 to 1.8 mmol/g, especially preferably 0.1 to 0.5 mmol/g. The alkenyl group content is in the above-mentioned range, and therefore there can be obtained the UV-curable silicone composition having both excellent curing properties in the portion thereof which is not exposed to a light and in the thicknesswise direction and excellent storage stability. When the component (A) is a mixture of a plurality of polyorganosiloxanes, the alkenyl group content of the component (A) is an average of the mixture.

The alkenyl group content of the component (A) can be determined from an absorbance (around 2,150 nm) of a CH₂=CH- group measured by means of a spectrophotometer.

In an embodiment of the present invention, the component (A) has per molecule at least two alkenyl groups bonded to silicon atoms. The component (A) undergoes an addition reaction with a hydrosilyl group (Si-H group) of the below-mentioned component (B) to form a network structure. The component (A) typically has in the molecule thereof at least two alkenyl group-containing siloxane units represented by the following general formula (1):

R¹ₘR²ₙSiO_{(4-m-n)/2} (1)

wherein:
R¹ is an unsubstituted or substituted monovalent hydrocarbon group
having no aliphatic unsaturated bond;
R² is an alkenyl group;
m is an integer of 0 to 2; and
n is an integer of 1 to 3, with the proviso that m + n is 1 to 3.

R¹ is an unsubstituted or substituted monovalent hydrocarbon group having no aliphatic unsaturated bond. Specific examples of R¹'s include alkyl groups, such as C₁-C₆ alkyl groups (e.g., methyl, ethyl, and propyl); cycloalkyl groups, such as C₃-C₁₀ cycloalkyl groups (e.g., cuclohexyl); aryl groups, such as C₆-C₂₀ aryl groups (e.g., phenyl, tolyl, xylyl, naphthyl, and anthracenyl); aralkyl groups, such as C₇-C₁₃ aralkyl groups (e.g., 2-phenylethyl and 2-phenylpropyl); and substituted hydrocarbon groups, such as halogen substituted hydrocarbon groups (e.g., chloromethyl, chlorophenyl, and 3,3,3-trifluoropropyl). In view of, for example, easy synthesis, alkyl groups are preferred, and, of these, methyl, ethyl, and propyl are preferred, and methyl is more preferred. For controlling the refractive index, an aryl group can be used together, and especially, in view of, for example, easy synthesis, phenyl is preferred.

From the viewpoint of obtaining the UV-curable silicone composition having excellent curing properties and storage stability, the component (A) preferably contains a linear polyorganosiloxane having one alkenyl group at each of the ends of the molecular principal chain. In an embodiment of the present invention, the linear polyorganosiloxane can be represented by, for example, the following formula (I): 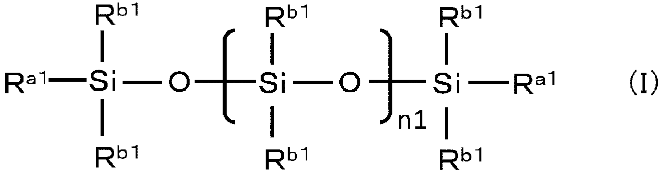 wherein:
each R^{a1} is independently a C₂-C₆ alkenyl group,
each R^{b1} is independently a C₁-C₆ alkyl group or a C₆-C₂₀ aryl group, and
n1 is such a number that the linear polyorganosiloxane has an alkenyl
group content of 0.08 mmol/g or more on an average.

Examples of C₂-C₆ alkenyl groups include a vinyl group, an allyl group, a 3-butenyl group, and a 5-hexenyl group. Examples of C₁-C₆ alkyl groups include a methyl group, an ethyl group, a propyl group, a butyl group, a pentyl group, and a hexyl group. Examples of C₆-C₂₀ aryl groups include a phenyl group, a naphthyl group, and an anthracenyl group.

R^{a1} is preferably a vinyl group in view of easy synthesis and not sacrificing the fluidity of the composition before cured and the heat resistance of the cured product. In view of easy synthesis and excellent balance between the fluidity of the composition and the mechanical strength of the cured product, R^{b1} is preferably a C₁-C₆ alkyl group, especially preferably a methyl group. Accordingly, the component (A) is preferably a polymethylvinylsiloxane having both ends capped by a dimethylvinylsiloxane unit, and having an intermediate unit comprised of a dimethylsiloxane unit.

The amount of the contained polymethylvinylsiloxane having both ends capped by a dimethylvinylsiloxane unit, and having an intermediate unit comprised of a dimethylsiloxane unit is preferably 30% by mass or more, more preferably 50% by mass or more, further preferably 80% by mass or more, based on the mass of the component (A) (100% by mass). The upper limit of the amount of the contained polymethylvinylsiloxane is 100% by mass.

From the viewpoint of surely obtaining the stable liquid state of the composition and curing properties in the portion thereof which is not exposed to a light and in the thicknesswise direction, n1 is such a number that the linear polyorganosiloxane has an alkenyl group content of 0.08 mmol/g or more on an average, preferably 0.08 to 11.0 mmol/g, more preferably 0.09 to 5.0 mmol/g, further preferably 0.09 to 1.8 mmol/g, especially preferably 0.1 to 0.5 mmol/g.

The viscosity of the component (A) is a value as measured in accordance with JIS K 6249 using a rotational viscometer under conditions using a No. 1, 2, 3, or 4 rotor at 60 rpm and at 23°C.

The component (A) may be a mixture of a polymethylvinylsiloxane having both ends capped by a dimethylvinylsiloxane unit, and having an intermediate unit comprised of a dimethylsiloxane unit, as well as another linear, branched, or cyclic alkenyl group-containing polyorganosiloxane.

With respect to the component (A), one which is commercially available can be used. Further, a polyorganosiloxane having an alkenyl group introduced by a known reaction may be used. The compounds as the component (A) are distinguished from each other according to, for example, the position or type of the substituent or the polymerization degree, and a single compound may be solely used, or two or more compounds may be used in combination. The component (A) is a polyorganosiloxane, and therefore may be a mixture of polyorganosiloxanes having different polymerization degrees.

From the viewpoint of the balance between the handling properties, curing properties, and storage stability, the amount of the component (A) incorporated is preferably 70.0 to 99.8% by mass, more preferably 80.0 to 99.7% by mass, further preferably 90.0 to 99.7% by mass, based on the mass of the UV-curable silicone composition (100% by mass).

### <Polyorganohydrogensiloxane (B) having per molecule at least three hydrogen atoms bonded to silicon atoms>

Component (B) is a polyorganohydrogensiloxane having per molecule at least three hydrogen atoms bonded to silicon atoms. The component (B) serves as a crosslinking agent, and undergoes an addition reaction with an alkenyl group of the component (A) to form a network structure.

The hydrogen atoms of the component (B) may be bonded to a silicon atom at an end of the molecular chain, or may be bonded to a silicon atom in the middle of the molecular chain, or may be bonded to both of them. With respect to the molecular structure of the component (B), there is no particular limitation as long as the molecular structure has a siloxane bond as a main skeleton, and the molecular structure may be linear, branched, cyclic, or of a three-dimensional network, and the siloxane skeleton may be intermitted by a divalent organic group. Further, the component (B) may have a hydroxyl group or an alkoxy group, such as a methoxy group or an ethoxy group, bonded to a silicon atom. The component (B) may be used individually or in combination.

The component (B) typically has in the molecule thereof at least three siloxane units containing a hydrogen atom bonded to a silicon atom and being represented by the following general formula (2):

R³ₚH_{q}SiO_{(4-p-q)/2} (2)

wherein:
R³ is an unsubstituted or substituted monovalent hydrocarbon group
having no aliphatic unsaturated bond;
p is an integer of 0 to 2; and
q is an integer of 1 to 3, with the proviso that p + q is 1 to 3.
As examples of R³'s, there can be mentioned the same as those mentioned above for R¹ in the general formula (1), and preferred modes of R³ are similar to those of R¹. In the component (B), the number of hydrogen atoms bonded to silicon atoms per molecule is preferably 3 to 100, more preferably 5 to 50.

The component (B) comprises a polyorganohydrogensiloxane (B 1) having an R^{c1}₂HSiO_{1/2} unit (wherein each R^{c1} is independently a C₁-C₆ alkyl group or a C₆-C₂₀ aryl group) and a SiO_{4/2} unit. The present inventors have found that when the component (B) contains the component (B 1), the composition can be cured by irradiating the composition with an ultraviolet light in such a way that not only the irradiated range of the composition is cured, but also the cured range is three-dimensionally expanded, so that the composition has excellent curing properties in the portion of the composition, which is around the portion irradiated with an ultraviolet light and is not exposed to the light, and in the thicknesswise direction.

The component (B 1) may be branched, cyclic, or of a three-dimensional network structure (structure having SiO_{4/2} units arranged densely). In view of, for example, easy synthesis, R^{c1} is preferably a C₁-C₆ alkyl group, especially preferably methyl.

Especially, the component (B 1) is preferably a polyorganohydrogensiloxane having a structure in which 3 to 6 SiO_{4/2} units and 6 to 12 R^{c1}₂HSiO_{1/2} units are bonded to each other; especially preferably a cyclic polyorganohydrogensiloxane having a structure in which 3 to 6 SiO_{4/2} units form a cyclic siloxane skeleton and two R^{c1}₂HSiO_{1/2} units are bonded to each SiO_{4/2} unit, such as [R^{c1}₂HSiO_{1/2}]₆[SiO_{4/2}]₃, [R^{c1}₂HSiO_{1/2}]₈[SiO_{4/2}]₄, [R^{c1}₂HSiO_{1/2}]₁₀[SiO_{4/2}]₅, or [R^{c1}₂HSiO_{1/2}]₁₂[SiO_{4/2}]₆.

The component (B) preferably has a viscosity at 23°C of 1 to 100 mPa•s, more preferably 1 to 50 mPa•s. The viscosity is a value as measured in accordance with JIS K 6249 using a rotational viscometer under conditions using a No. 1 or 2 rotor at 60 rps and at 23°C.

With respect to the component (B), one which is commercially available can be used. Alternatively, the component (B) can be synthesized by a known reaction. The compounds as the component (B) are distinguished from each other according to, for example, the position or type of the substituent or the polymerization degree, and a single compound may be solely used, or two or more compounds may be used in combination. The component (B) is a polyorganohydrogensiloxane, and therefore may be a mixture of polyorganohydrogensiloxanes having different polymerization degrees.

From the viewpoint of the handling properties, curing properties, and expansion of the cured range, the ratio of a molar number H_{B} of the hydrogen atoms bonded to silicon atoms of the component (B) to a molar number Vi_{A} of the alkenyl groups of the component (A), i.e., the H_{B}/Vi_{A} ratio is preferably 0.30 to 3.5, more preferably 0.30 to 3.0, further preferably 0.40 to 2.0, further more preferably 0.45 to 1.1, especially preferably 0.50 to 1.0.

### <Platinum catalyst (C) which is capable of being activated by an ultraviolet light>

Component (C) is a catalyst which is capable of being activated by an ultraviolet light, and which is used for accelerating an addition reaction between an alkenyl group of the component (A) and a hydrosilyl group (Si-H group) of the component (B). From the viewpoint of excellent catalytic activity, the component (C) is preferably a platinum catalyst having a cyclic diene compound as a ligand. The component (C) may be used individually or in combination.

Examples of platinum catalysts having a cyclic diene compound as a ligand include a (1,5-cyclooctadienyl)diphenylplatinum complex, a (1,5-cyclooctadienyl)dipropylplatinum complex, a (2,5-norboradiene)dimethylplatinum complex, a (2,5-norboradiene)diphenylplatinum complex, a (cyclopentadienyl)dimethylplatinum complex, a (methylcyclopentadienyl)diethylplatinum complex, a (trimethylsilylcyclopentadienyl)diphenylplatinum complex, a (methylcycloocta-1,5-dienyl)diethylplatinum complex, a (cyclopentadienyl)trimethylplatinum complex, a (cyclopentadienyl)ethyldimethylplatinum complex, a (cyclopentadienyl)acetyldimethylplatinum complex, a (methylcyclopentadienyl)trimethylplatinum complex, a (methylcyclopentadienyl)trihexylplatinum complex, a (trimethylsilylcyclopentadienyl)trimethylplatinum complex, a (dimethylphenylsilylcyclopentadienyl)triphenylplatinum complex, and a (cyclopentadienyl)dimethyltrimethylsilylmethylplatinum complex.

The amount of the component (C) incorporated into the UV-curable silicone composition is 8 to 400 ppm, in terms of a platinum metal mass. When the amount of the component (C) incorporated is less than 8 ppm, in terms of a platinum metal mass, the UV-curable silicone composition has poor curing properties in the portion thereof, which is around the portion irradiated with an ultraviolet light and is not exposed to the light, and in the thicknesswise direction. When the amount of the component (C) incorporated is more than 400 ppm, in terms of a platinum metal mass, it is likely that the UV-curable silicone composition has poor storage stability and a cured product obtained from the composition suffers yellowing, and the cost is increased. The amount of the component (C) incorporated into the UV-curable silicone composition is preferably 30 to 350 ppm, more preferably 37 to 350 ppm, further preferably 40 to 350 ppm, especially preferably 70 to 340 ppm, in terms of a platinum metal mass.

Similarly, the amount of the component (C) incorporated, based on the total mass of component (A) and component (B), is preferably 8 to 400 ppm, more preferably 30 to 350 ppm, further preferably 37 to 350 ppm, further more preferably 40 to 350 ppm, especially preferably 70 to 340 ppm, in terms of a platinum metal mass.

### <Additional component>

In the UV-curable silicone composition, an additional component can be incorporated as long as the object and effects of the present invention are not sacrificed. As an additional component, for example, a flame retardant, an adhesion imparting agent, a heat resistance imparting agent, a diluent, a thixotropic agent, such as fumed silica, an inorganic or organic pigment, an inhibitor for addition reaction curing catalyst, or a resin other than the polyorganosiloxane can be appropriately incorporated into the composition. Further, in the UV-curable silicone composition, a polyorganosiloxane other than the component (A), for example, a polyorganosiloxane having one alkenyl group or less per molecule; or a polyorganohydrogensiloxane other than the component (B), for example, a polyorganohydrogensiloxane having per molecule one or two hydrogen atoms bonded to silicon atoms can be incorporated. The additional components may be used individually or in combination.

### <Method for producing the UV-curable silicone composition>

The UV-curable silicone composition can be obtained by mixing the components (A) to (C) and, if necessary, further an additional component by means of a mixing machine, such as a planetary mixer. The components may be mixed, if necessary, while heating at a temperature in the range of from 50 to 150°C. When the UV-curable silicone composition contains a powder, it is preferred that a kneading operation for the composition under a high shear force is conducted for uniform finish. Examples of kneading machines include a three-roll, a colloid mill, and a sand grinder, and, of these, preferred is a method using a three-roll.

The UV-curable silicone composition can be a two-pack type composition, taking the storage stability of the composition into consideration. When the UV-curable silicone composition is a two-pack type composition, it is preferred that a first agent contains the component (A) and the component (C) and does not contain the component (B), and that a second agent contains the component (B) and does not contain the component (C). In the two-pack type UV-curable silicone composition, the first agent and second agent are separately prepared. The first agent and second agent can be produced by the same method as that for a one-pack type composition.

The UV-curable silicone composition has a viscosity of 10 to 10,000 mPa•s at 23°C. The viscosity of the composition is in the above-mentioned range, and therefore the composition has excellent handling properties and can be improved in curing properties in the portion of the composition, which is around the portion irradiated with an ultraviolet light and is not exposed to the light, and in the thicknesswise direction. The viscosity of the UV-curable silicone composition at 23°C is preferably 20 to 5,000 mPa•s, more preferably 100 to 2,000 mPa•s.

When the UV-curable silicone composition is a two-pack type composition comprising a first agent and a second agent, the viscosity of the first agent and second agent is preferably 10 to 20,000 mPa•s, more preferably 20 to 10,000 mPa•s, especially preferably 100 to 5,000 mPa•s. The viscosity is a value as measured in accordance with JIS K 6249 using a rotational viscometer under conditions using a No. 1, 2, 3, or 4 rotor at 60 rpm and at 23°C. The UV-curable silicone composition is preferably stored under light shielding conditions at a temperature of room temperature or lower.

### <Method for curing the UV-curable silicone composition>

The UV-curable silicone composition can be cured by irradiation with an ultraviolet light. The irradiation dose is preferably 100 to 10,000 mJ/cm², more preferably 300 to 6,000 mJ/cm², further preferably 500 to 5,000 mJ/cm². The irradiation dose is a value measured with respect to a UVA. The UVA means an ultraviolet light having a wavelength in the range of from 315 to 400 nm. The composition has excellent curing properties when irradiating the composition with an ultraviolet light having a wavelength, for example, in the range of from 250 to 450 nm. Examples of light sources which emit an ultraviolet light having such a wavelength include a high-pressure mercury lamp (UV-7000) and a metal halide lamp (UVL-4001M3-N1), manufactured by Ushio Inc.; a metal halide lamp (JM-MTL 2KW), manufactured by JM Tech Co., Ltd., Korea; an ultraviolet light irradiation lamp (OSBL360), manufactured by Mitsubishi Electric Corporation; an ultraviolet light irradiation machine (UD-20-2), manufactured by GS Yuasa International Ltd.; a fluorescent lamp (FL-20BLB), manufactured by Toshiba Corporation; H Bulb, H plus Bulb, V Bulb, D Bulb, Q Bulb, and M Bulb, manufactured by Heraeus Co., Ltd.; and an LED lamp (HLDL-155UV), manufactured by CCS Inc.

The curing time for the composition varies depending on the irradiation dose of an ultraviolet light, but is generally 30 minutes or less, preferably 10 minutes or less. It is possible to visually check whether curing of the composition is proceeding, but quantitative evaluation can be made from, for example, a period of time required until the storage modulus G' has become equal to the loss modulus G", or a period of time required until the storage modulus G' has reached a predetermined value. For example, after irradiation with an ultraviolet light, a period of time required until the storage modulus G' has become equal to the loss modulus G" under conditions at 23°C is 30 minutes or less, preferably 10 minutes or less, because the time needed for curing is short such that the handling properties are excellent.

### <Curing properties of the UV-curable silicone composition>

The UV-curable silicone composition has excellent curing properties in the portion thereof which is not exposed to a light and in the thicknesswise direction. Specifically, a cured product of the UV-curable silicone composition has a cured diameter of 10.8 mm or more at a depth of 1.8 mm, wherein the cured product is obtained by irradiating the composition with an ultraviolet light having a diameter of 7.0 mm, an illuminance of 100 mW/cm², and a wavelength of 365 nm for 45 seconds in a yellow room, and then allowing the resultant composition to stand at 23°C for 16 hours. The cured diameter is preferably 11.0 mm or more, more preferably 12.0 mm or more, further preferably 13.0 mm or more.

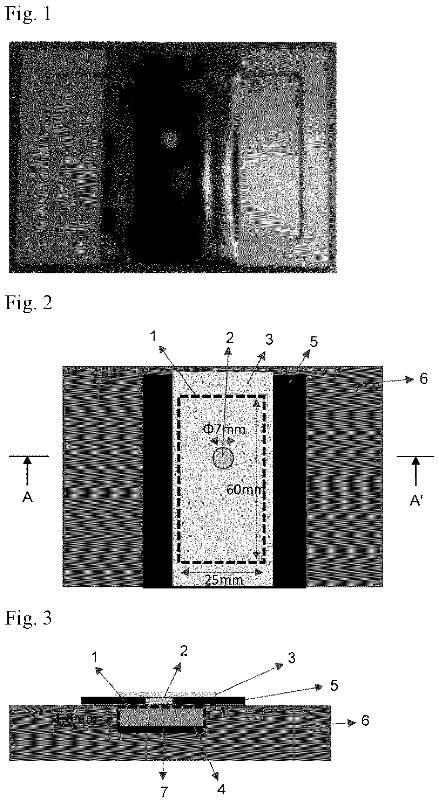

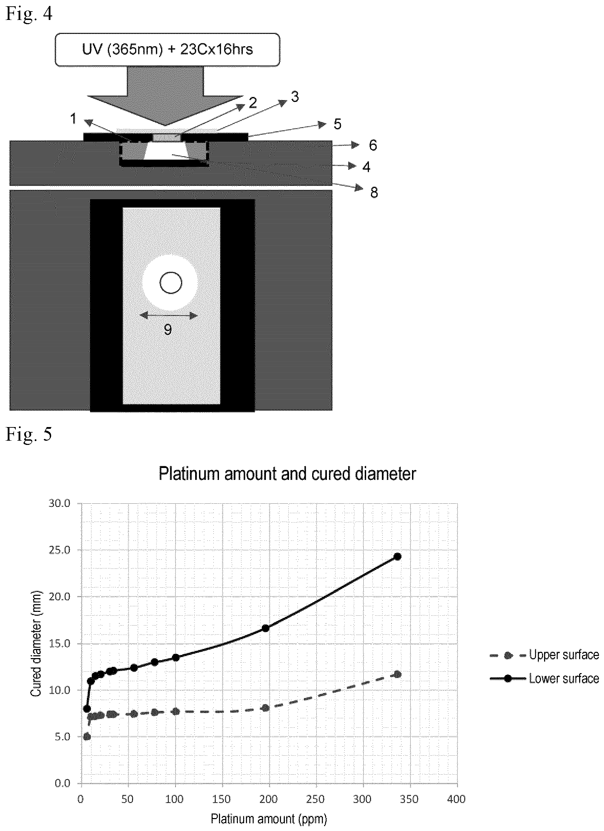

A method for measuring the cured diameter is described with reference to Figs. 1 to 4. Fig. 1 is a photograph of an apparatus for measuring a cured diameter in a yellow room, taken from above, and Fig. 2 is a schematic diagram of the apparatus as viewed from above. Fig. 3 is a cross-sectional diagram of Fig. 2, taken along line A-A'. Fig. 4 is a schematic diagram explaining the cured region and cured diameter after irradiation with an ultraviolet light in Figs. 2 and 3.

The yellow room indicates an environment which blocks a light having a wavelength of 500 nm or less including an ultraviolet light, and specifically means an environment which cuts 98% or more of the wavelength of 500 nm or less from a light of fluorescent light. The yellow room is generally provided, for example, when handling a photosensitive material in a clean room of a semiconductor plant. For example, a yellow room can be prepared by using a room having no window and using, as lighting, a commercially available yellow fluorescent light. As a commercially available yellow fluorescent light, for example, there can be mentioned a yellow light straight tube LED lamp, manufactured by Toshiba Corporation.

As shown in Figs. 2 and 3, metal die 6 is prepared wherein the metal die has depression 1 (defined by the broken line in Figs. 2 and 3) of a rectangular parallelepiped having a length of 60 mm, a width of 25 mm, and a depth of 2.0 mm. For preventing reflection of an ultraviolet light, black tape 4 for bottom (thickness: 0.2 mm) is stuck on the entire bottom surface of depression 1. Then, in a yellow room, depression 1 is filled with sample 7 (each of the compositions in Examples and Comparative Examples), and black tape 5 for top (thickness: 0.2 mm) having therein hole 2 having a diameter of 7.0 mm is applied so as to cover the top portion of the composition. Further, on black tape 5 for top is placed transparent glass 3 having a thickness of 1 mm and having a size larger than that of depression 1.

The thus prepared sample 7 is irradiated through hole 2 with an ultraviolet light having an illuminance of 100 mW/cm² and a wavelength of 365 nm (irradiation dose: 4,500 mJ/cm²) for 45 seconds using a UV-LED irradiation apparatus, manufactured by CCS Inc., and then allowed to stand at 23°C for 16 hours. Sample 7 is cured in the range of cured region 8 as shown in Fig. 4. Black tape 5 for top is peeled off, and metal die 6 is made vertical to remove the uncured portion, and a maximum diameter of each of the cured upper surface and lower surface is measured by means of a vernier caliper and determined as a cured diameter.

### <Use of the UV-curable silicone composition>

The cured product of the UV-curable silicone composition has excellent bonding properties and transparency, and therefore the composition can be advantageously used as a potting material. Specifically, the UV-curable silicone composition can be advantageously used for a material having a portion which is unlikely to be exposed to a light, particularly as a potting material for use in a connector pin.

In another embodiment of the present invention, the cured product of the UV-curable silicone composition can be advantageously used as an encapsulant. An article using the cured product of the UV-curable silicone composition as an encapsulant has excellent water resistance and durability performance with respect to the bonding surface and encapsulation site, and therefore the cured product can be advantageously used as an encapsulant for an electric part or an electronic part. Further, the UV-curable silicone composition has excellent curing properties in the portion thereof, which is around the portion irradiated with an ultraviolet light and is not exposed to the light, and in the thicknesswise direction, and a cured product of the composition has stable quality. Therefore, the cured product can be used as, for example, an adhesive for lamination in an image display device, such as a liquid crystal, plasma, or organic EL image display device, or an encapsulant for encapsulation of an LED element or an OLED element. Particularly, the encapsulant comprising a cured product of the UV-curable silicone composition can be advantageously used for an electric part or an electronic part, especially advantageously used for a connector having a connector pin.

### Examples

Hereinbelow, the present invention will be described in more detail with reference to the following Examples and Comparative Examples, which should not be construed as limiting the scope of the present invention. The indication "parts" or "%" means "parts by mass" or "% by mass" unless otherwise specified.

### <Components used>

The components used are as shown below. The symbols have the following meanings.

M: (CH₃)₃SiO_{1/2}

M^{H}: H(CH₃)₂SiO_{1/2}

M^{Vi}: CH₂=CH(CH₃)₂SiO_{1/2}

D: (CH₃)₂SiO_{2/2}

D^{H}: H(CH₃)SiO_{2/2}

D^{Vi}: CH₂=CH(CH₃)SiO_{2/2}

Q: SiO_{4/2} (tetrafunctional)

Component (A): Polyorganosiloxane having at least two alkenyl groups per molecule and having an alkenyl group content of 0.08 mmol/g or more on an average

The below-shown polymethylvinylsiloxanes having both ends capped by an M^{Vi} unit and having an intermediate unit comprised of a D unit were used.
M^{Vi}Dₘ₁M^{Vi} (1): vinyl group content on an average: 0.346 mmol/g; viscosity at 23°C: 140 mPa•s
M^{Vi}Dₘ₂M^{Vi} (2): vinyl group content on an average: 0.106 mmol/g; viscosity at 23°C: 1,400 mPa•s
M^{Vi}Dₘ₅M^{Vi} (5): vinyl group content on an average: 0.145 mmol/g; viscosity at 23°C: 1,200 mPa•s

Component (A'): Polyorganosiloxane having at least two alkenyl groups per molecule and having an alkenyl group content of less than 0.08 mmol/g on an average
M^{Vi}Dₘ₃M^{Vi} (3): vinyl group content on an average: 0.047 mmol/g; viscosity at 23°C: 13,000 mPa•s
M^{Vi}Dₘ₄M^{Vi} (4): vinyl group content on an average: 0.029 mmol/g; viscosity at 23°C: 78,000 mPa•s

The alkenyl group content of each of the components (A) and (A') was determined from an absorbance (around 2,150 nm) of a CH₂=CH- group measured by means of a spectrophotometer.

Component (B): Polyorganohydrogensiloxane having per molecule at least three hydrogen atoms bonded to silicon atoms
Crosslinkable polymethylhydrogensiloxane having an average unit formula represented by M^{H}₈Q₄ (SiH amount: 10.11 mmol/g)
Crosslinkable polymethylhydrogensiloxane having an average unit formula represented by M^{H}D^{H}₉D₁₁M^{H} (SiH amount: 8.27 mmol/g)
Crosslinkable polymethylhydrogensiloxane having an average unit formula represented by MD^{H}₂₃D₁₆M (SiH amount: 8.60 mmol/g)

Component (C): Platinum catalyst which is capable of being activated by an ultraviolet light
(Methylcyclopentadienyl)trimethylplatinum complex (manufactured by Strem Chemicals, Inc. (Germany); platinum amount: 61.1% by mass)

### Other components

(1) Polyorganosiloxane having per molecule at least two hydrogen atoms bonded to sulfur atoms (SH amount: 0.96 mmol/g)
(2) Acrylic monomer: 4-Hydroxybutyl acrylate (4HBA, manufactured by Mitsubishi Chemical Corporation)
(3) Photoinitiator: 2-Hydroxy-2-methyl-1-phenylpropanone (Irgacure (registered trademark) 1173, manufactured by IGM Resins B.V.). A 1.0% by mass diluted liquid was used.

### Example 1

Preparation of a composition was conducted in a yellow room. Component (C) was diluted with M^{Vi}Dₘ₁M^{Vi} (1) so as to have a concentration of 1.0% by mass. To 91.30 parts by mass of M^{Vi}Dₘ₁M^{Vi} (1) were added 5.50 parts by mass of the diluted liquid of component (C) (component (C): 0.055 parts by mass; M^{Vi}Dₘ₁M^{Vi} (1): 5.445 parts by mass) and 3.20 parts by mass of component (B), and mixed with one another, obtaining an UV-curable silicone composition in Example 1.

### Examples 2 to 14

UV-curable silicone compositions in Examples 2 to 14 were individually obtained in substantially the same manner as in Example 1 except that components (A) to (C) and the formulation were changed to those shown in Table 1.

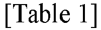

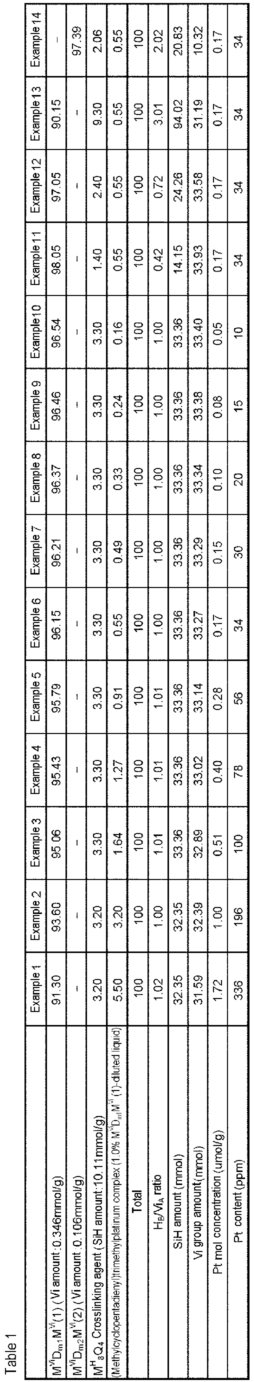

### Comparative Examples 1 to 15

UV-curable compositions in Comparative Examples 1 to 15 were individually obtained in substantially the same manner as in Example 1 except that the components and the formulation were changed to those shown in Table 2.

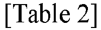

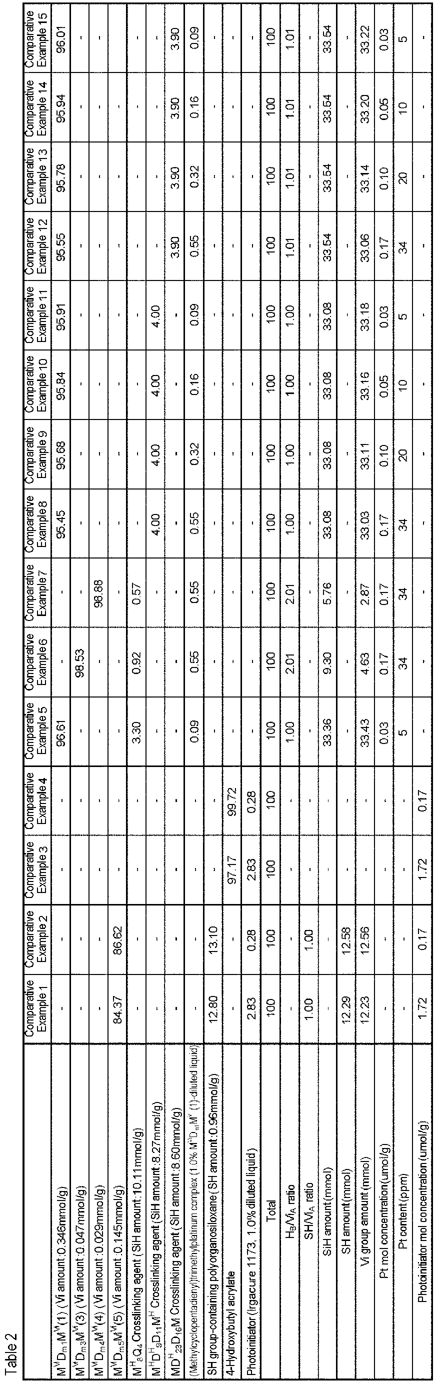

### <Measurement method>

### [Viscosity]

With respect to the compositions in Examples 1 to 14 and Comparative Examples 1 to 15, a viscosity at 23°C was measured at 60 rpm in accordance with JIS K 6249 using a rotational viscometer (Vismetron Model VDA2, manufactured by Shibaura System Co., Ltd.) and using a No. 2 rotor. With respect to each of the composition immediately after prepared and the composition obtained after allowed to stand at 23°C for 24 hours outside of the yellow room, a viscosity was measured. The results are shown in Tables 3 and 4.

### [Shore 00 hardness]

The compositions in Examples 1 to 14 and Comparative Examples 1 to 15 were individually allowed to flow into a die having a size of length: 100 mm × width: 100 mm × depth: 2 mm, and cured by irradiation with an ultraviolet light having an illuminance of 100 mW/cm² for 45 seconds using HLDL-155UV, manufactured by CCS Inc., and then further allowed to stand at 23°C at 50 RH% for 16 hours. With respect to the thus obtained cured product, a Shore 00 hardness was measured in accordance with ASTM D 2240. When the composition was not cured by irradiation with an ultraviolet light, the composition had a rating "uncured". The results are shown in Tables 3 and 4.

### [Gel time]

With respect to the compositions in Examples 1 to 14 and Comparative Examples 1 to 15, using a viscoelasticity measurement apparatus MCR301 (manufactured by Anton Paar GmbH), a storage modulus G' was measured with time from the start of irradiation with an ultraviolet light. Using the viscoelasticity measurement apparatus, and using Φ12 mm parallel plates, measurement of a storage modulus G' of the UV-curable silicone composition at 23°C was started with a gap of 0.5 mm, a frequency of 1 Hz, and a strain of 1%. The UV-curable silicone composition was irradiated with an ultraviolet light having an illuminance of 100 mW/cm² for 45 seconds (irradiation dose: 4,500 mJ/cm²), and a period of time required until the storage modulus G' became equal to the loss modulus G" from the start of irradiation was determined as a gel time. The shorter the gel time, the quicker the curing properties, or the more excellent the curing properties. The measurement of a gel time was performed until 60 minutes after the start of irradiation with an ultraviolet light, and, when the storage modulus G' was less than the loss modulus G", the composition had a rating "uncured". The results are shown in Tables 3 and 4.

### [Cured diameter]

A cured diameter was measured as an index for the range of the cured composition and the degree of expansion of the range of the cured composition from the range of the composition irradiated with an ultraviolet light. Fig. 1 is a photograph of an apparatus for the measurement in a yellow room, taken from above, and Fig. 2 is a schematic diagram of the apparatus as viewed from above. Fig. 3 is a cross-sectional diagram of Fig. 2, taken along line A-A'. Fig. 4 is a schematic diagram explaining the cured region and cured diameter after irradiation with an ultraviolet light in Figs. 2 and 3.

As shown in Figs. 2 and 3, metal die 6 was prepared wherein the metal die had depression 1 (defined by the broken line in Figs. 2 and 3) of a rectangular parallelepiped having a length of 60 mm, a width of 25 mm, and a depth of 2.0 mm. For preventing reflection of an ultraviolet light, black tape 4 for bottom (thickness: 0.2 mm) was stuck on the entire bottom surface of depression 1. Then, in a yellow room, depression 1 was filled with sample 7 (each of the compositions in Examples and Comparative Examples), and black tape 5 for top (thickness: 0.2 mm) having therein hole 2 having a diameter of 7.0 mm was applied so as to cover the top portion of the composition. Further, on black tape 5 for top was placed transparent glass 3 having a thickness of 1 mm and having a size larger than that of depression 1.

The thus prepared sample 7 was irradiated through hole 2 with an ultraviolet light having an illuminance of 100 mW/cm² and a wavelength of 365 nm (irradiation dose: 4,500 mJ/cm²) for 45 seconds using a UV-LED irradiation apparatus, manufactured by CCS Inc., and then allowed to stand at 23°C for 16 hours. Sample 7 was cured in the range of cured region 8 as shown in Fig. 4. Black tape 5 for top was peeled off, and metal die 6 was made vertical to remove the uncured portion, and a maximum diameter of each of the cured upper surface and lower surface was measured by means of a vernier caliper and determined as a cured diameter. With respect to the cured diameter, when the cured diameter in the upper surface was more than 7.0 mm and the cured diameter in the lower surface was 10.8 mm or more, the curing properties in the portion of the composition, which is around the portion irradiated with an ultraviolet light and is not exposed to the light, and in the thicknesswise direction were judged to be excellent. When the composition was not cured by irradiation with an ultraviolet light, the composition had a rating "uncured". The results are shown in Tables 3 and 4.

A cured area of the unirradiated portion was determined as an index for the degree of expansion of the range of the cured composition from the range of the composition irradiated with an ultraviolet light. With respect to the composition in each of Examples and Comparative Examples, on the assumption that the cured composition is in the circular form, a total cured area was first calculated from the cured diameter of each of the upper surface and lower surface of sample 7. Then, a difference between the total cured area of each of the upper surface and lower surface and the area irradiated with an ultraviolet light (area of hole 2) was determined as a cured area of the unirradiated portion. The results are shown in Tables 3 and 4.

### [Table 3]

**Table 3**

| Evaluation items | | Unit | Example 1 | Example 2 | Example 3 | Example 4 | Example 5 | Example 6 | Example 7 | Example 8 | Example 9 | Example 1 0 | Example11 | Example12 | Example13 | Example14 |
|---|---|---|---|---|---|---|---|---|---|---|---|---|---|---|---|---|
| Viscosity (immediately after prepared) | | mPa·s | 126.0 | 125.5 | 125.0 | 125.0 | 125.0 | 125.0 | 124.5 | 123.0 | 124.5 | 124.0 | 126.5 | 123.5 | 114.0 | 1380.0 |
| Viscosity (23°C, after 24 hr) | | mPa.s | 166.5 | 152.0 | 140.0 | 132.5 | 128.5 | 126.0 | 126.0 | 123.5 | 124.0 | 124.0 | 127.0 | 129.5 | 120.0 | 1380.0 |
| Shore 00 hardness ASTM D2240 | | | 80 | 80 | 79 | 79 | 79 | 79 | 79 | 79 | 77 | 75 | 3 | 60 | 75 | 74 |
| Gel time (UV irradiation(4,500mJ/cm²), 23°C) | | Min. | 0.3 | 0.5 | 1.0 | 1.2 | 1.4 | 1.7 | 1.7 | 2.2 | 3.0 | 4.5 | 8.6 | 2.1 | 0.9 | 1.2 |
| Cured diameter | Upper surface | mm | 11.7 | 8.1 | 7.7 | 7.6 | 7.5 | 7.4 | 7.4 | 7.3 | 7.2 | 7.1 | 7.2 | 7.3 | 7.5 | 74 |
| | Lower surface | mm | 24.3 | 16.7 | 13.5 | 13.0 | 12.4 | 12.1 | 12.0 | 11.7 | 11.5 | 11.0 | 11.2 | 11.6 | 12.7 | 10.8 |
| Cured area of unirradiated portion | Upper surface | mm² | 69.0 | 13.0 | 8.1 | 7.1 | 5.1 | 4.5 | 4.5 | 3.4 | 2.2 | 1.6 | 2.2 | 3.4 | 5.7 | 4.5 |
| | Lower surface | mm² | 425.1 | 179.4 | 104.6 | 94.2 | 82.2 | 76.5 | 74.6 | 69.0 | 65.9 | 55 8 | 60.0 | 67.2 | 88.1 | 53.1 |

### [Table 4]

**Table 4**

| Evaluation items | | Unit | Comparative Example 1 | Comparative Example2 | Comparative Examples | Comparative Example4 | Comparative Examples | Comparative Example6 | Comparative Example7 | Comparative Examples | Comparative Example 9 | Comparative Example10 | Comparative Example11 | Comparative Example12 | Comparative Example13 | Comparative Example14 | Comparative Example15 |
|---|---|---|---|---|---|---|---|---|---|---|---|---|---|---|---|---|---|
| Viscosity (immediately after prepared) | | mPa·s | 920.0 | 900.0 | 12.0 | 12.0 | 123.0 | 12500.0 | 73900.0 | 118.5 | 118.0 | 118.5 | 117.0 | 121.0 | 121.5 | 122.5 | 122.5 |
| Viscosity (23°C, after 24 hr) | | mPa·s | 9200 | 900.0 | 12.0 | 120 | 123.0 | 12800.0 | 76100.0 | 118.5 | 120.0 | 120.0 | 117.5 | 122.5 | 125.0 | 123.0 | 123.0 |
| Shore 00 hardness ASTM D2240 | | | 70 | Uncured | 46 | Uncured | 72 | 71 | 69 | 79 | 79 | 78 | 75 | 81 | 80 | 79 | 77 |
| Gel time (UV irradiation (4,500mJ/cm²), 23°C) | | Min. | 0.2 | Uncured | 0.2 | Uncured | 5.8 | 0.9 | 0.8 | 0.6 | 0.7 | 1.2 | 2.0 | 0.6 | 0.8 | 1.3 | 2.5 |
| Cured diameter | Upper surface | mm | 7.0 | Uncured | 7.0 | Uncured | 5.0 | 7.3 | 7.2 | 7.8 | 7.5 | 7.4 | 7.3 | 7.7 | 7.5 | 7.1 | 7.0 |
| | Lower surface | mm | 8.4 | Uncured | 7.2 | Uncured | 8.0 | 10.5 | 9.5 | 10.6 | 10.4 | 10.0 | 9.8 | 10.6 | 10.3 | 10.0 | 9.8 |
| Cured area of unirradiated portion | Upper surface | mm² | 0.0 | Uncured | 0.0 | Uncured | -18.8 | 3.4 | 2.2 | 9.3 | 5.7 | 3.9 | 3.4 | 8.1 | 5.7 | 1.1 | 0.0 |
| | Lower surface | mm² | 16.5 | Uncured | 2.7 | Uncured | 11.8 | 48.6 | 32.4 | 49.7 | 46.4 | 40.0 | 36.9 | 49.7 | 44.8 | 400 | 36.9 |

As can be seen from Table 3, the UV-curable silicone composition in Examples is a UV-curable silicone composition comprising a polyorganosiloxane (A) having at least two alkenyl groups per molecule and having an alkenyl group content of 0.08 mmol/g or more on an average; a polyorganohydrogensiloxane (B) having per molecule at least three hydrogen atoms bonded to silicon atoms; and a platinum catalyst (C) which is capable of being activated by an ultraviolet light, the component (B) comprising a polyorganohydrogensiloxane (B1) having an R^{c1}₂HSiO_{1/2} unit (wherein each R^{c1} is independently a C₁-C₆ alkyl group or a C₆-C₂₀ aryl group) and a SiO_{4/2} unit, wherein the amount of the component (C) incorporated into the composition is 8 to 400 ppm, in terms of a platinum metal mass, and wherein the composition has a viscosity of 10 to 10,000 mPa•s at 23°C, and the UV-curable silicone composition in Examples had a short gel time and excellent curing properties as well as excellent curing properties in the portion thereof which was not exposed to a light and in the thicknesswise direction.

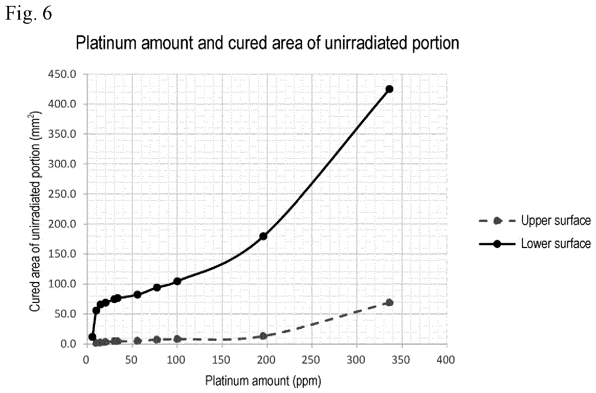

As seen from a comparison of Examples 1 to 10 and Comparative Example 5, there is a tendency that, as the amount of the component (C) incorporated into the composition is increased, the cured diameter and the cured area of the unirradiated portion are increased. Fig. 5 is a graph showing the relationship between the amount of the platinum incorporated with the cured diameter in the upper surface (depth: 0 mm) and the lower surface (depth: 1.8 mm) of sample 7 with respect to Examples 1 to 10 and Comparative Example 5. Similarly, Fig. 6 is a graph showing the relationship between the amount of the platinum incorporated with the cured area of the unirradiated portion in the upper surface and the lower surface of sample 7 with respect to Examples 1 to 10 and Comparative Example 5. As can be seen from Figs. 5 and 6, points of inflection are observed around 56 ppm and 196 ppm of the amount of the component (C) incorporated. It is preferred that the amount of the component (C) incorporated exceeds these values, because a tendency is seen such that particularly the cured diameter and the cured area of the unirradiated portion at a depth of 1.8 mm are markedly increased.

Further, in Example 6 in which the alkenyl group content of the component (A) is 0.346 mmol/g, the cured diameter in the lower surface (depth: 1.8 m) of the sample was large, and thus the curing properties in the thicknesswise direction were excellent, as compared to those in Example 14 in which the alkenyl group content is 0.106 mmol/g.

In Comparative Examples 1 and 2 in which, instead of the component (B), a polyorganosiloxane having per molecule at least two hydrogen atoms bonded to sulfur atoms was used, and a photoinitiator was used, and in Comparative Examples 3 and 4 in which an acrylic monomer and a photoinitiator were used, the curing properties in the portion thereof which was not exposed to a light and in the thicknesswise direction were poor. Particularly, in Comparative Examples 2 and 4 in which the amount of the photoinitiator contained was 0.17 µmol/g, the composition was not able to be cured. In Comparative Example 5 in which the components (A) to (C) are used, but the amount of the component (C) incorporated into the composition is less than 8 ppm, in terms of a platinum metal mass, the curing properties in the portion thereof which was not exposed to a light and in the thicknesswise direction were poor.

In Comparative Examples 6 and 7 in which component (A) has an alkenyl group content of less than 0.08 mmol/g on an average and the composition has a viscosity at 23°C of more than 10,000 mPa•s, the cured diameter at a depth of 1.8 mm was small, and the curing properties in the thicknesswise direction were poor. In Comparative Examples 8 to 15 in which component (B) was a linear polyorganohydrogensiloxane, the cured diameter at a depth of 1.8 mm was small, and the curing properties in the thicknesswise direction were poor. Particularly, from a comparison of Examples 6, 8, and 10 with Comparative Examples 8 to 10 or Comparative Examples 12 to 14, it is apparent that, with respect to the composition in Examples in which component (B) was the component (B 1), the cured diameter and the cured area of the unirradiated portion at a depth of 1.8 mm were extremely excellent, as compared to those of the composition in Comparative Examples in which component (B) was a linear polyorganohydrogensiloxane.

### Industrial Applicability

The cured product of the UV-curable silicone composition is advantageously used as an encapsulant for, for example, electric parts and electronic parts.

### Reference Signs List

- 1:: Depression
- 2:: Hole
- 3:: Transparent glass
- 4:: Black tape for bottom
- 5:: Black tape for top
- 6:: Metal die
- 7:: Sample (UV-curable silicone composition)
- 8:: Cured region
- 9:: Cured diameter

## Claims

1. A UV-curable silicone composition comprising:
a polyorganosiloxane (A) having at least two alkenyl groups per molecule and having an alkenyl group content of 0.08 mmol/g or more on an average;
a polyorganohydrogensiloxane (B) having per molecule at least three hydrogen atoms bonded to silicon atoms; and
a platinum catalyst (C) which is capable of being activated by an ultraviolet light,
the component (B) comprises a polyorganohydrogensiloxane (B1) having an R^{c1}₂HSiO_{1/2} unit (wherein each R^{c1} is independently a C₁-C₆ alkyl group or a C₆-C₂₀ aryl group) and a SiO_{4/2} unit,
the amount of the component (C) incorporated into the composition is 8 to 400 ppm, in terms of a platinum metal mass,
the composition has a viscosity of 10 to 10,000 mPa•s at 23°C, and
a cured product of the composition has a cured diameter of 10.8 mm or more at a depth of 1.8 mm, wherein the cured product is obtained by irradiating the composition with an ultraviolet light having a diameter of 7.0 mm, an illuminance of 100 mW/cm², and a wavelength of 365 nm for 45 seconds in a yellow room, and then allowing the resultant composition to stand at 23°C for 16 hours.

2. The UV-curable silicone composition according to claim 1, wherein the component (A) contains a linear polyorganosiloxane, and the component (A) has an alkenyl group content of 0.09 to 1.8 mmol/g on an average.

3. The UV-curable silicone composition according to claim 1 or 2, wherein the amount of the component (C) incorporated into the composition is 40 to 350 ppm, in terms of a platinum metal mass.

4. The UV-curable silicone composition according to claim 1 or 2, wherein the component (B1) is a polyorganohydrogensiloxane having a structure in which 3 to 6 SiO_{4/2} units and 6 to 12 R^{c1}₂HSiO_{1/2} units are bonded to each other.

5. The UV-curable silicone composition according to claim 1 or 2, wherein the component (C) is a platinum catalyst having a cyclic diene compound as a ligand.

6. The UV-curable silicone composition according to claim 1 or 2, wherein a H_{B}/Vi_{A} ratio, which is the ratio of a molar number H_{B} of the hydrogen atoms bonded to silicon atoms of the component (B) to a molar number Vi_{A} of the alkenyl groups of the component (A), is 0.30 to 3.5.

7. A potting material comprising the UV-curable silicone composition according to claim 1 or 2.

8. The potting material according to claim 7, which is for use in a connector pin.

9. An encapsulant comprising a cured product of the UV-curable silicone composition according to claim 1 or 2.

10. The encapsulant according to claim 9, which is for use in an electric part or an electronic part.

11. The encapsulant according to claim 10, wherein the electric part or electronic part is a connector having a connector pin.
